# EUROPÄISCHE PATENTSCHRIFT

(11) **EP 2 067 048 B1**
(45) Veröffentlichungstag und Bekanntmachung des Hinweises auf die Patenterteilung: **10.03.2010**
(21) Anmeldenummer: 07802091.4
(22) Anmeldetag: 03.09.2007
(51) Int. Cl.: G01R 29/08, H04B 17/00, H01Q 21/24

(54) **ANTENNENKOPPLER**
ANTENNA COUPLER
COUPLEUR D'ANTENNE

(30) Priorität: 27.09.2006 DE 102006045645
(43) Veröffentlichungstag der Anmeldung: 10.06.2009
(73) Patentinhaber: Rohde & Schwarz GmbH & Co. KG, 81671 München (DE)
(72) Erfinder: MAUKSCH, Thomas, 83104 Tuntenhausen (DE)
(74) Vertreter: Körfer, Thomas
(86) Internationale Anmeldenummer: PCT/EP2007/007676
(87) Internationale Veröffentlichungsnummer: WO 2008/037333

(56) Entgegenhaltungen:
- WO-A-02/103840
- US-A- 4 588 993
- ALASDAIR PHILIPS: "MEASURING MAGNETIC FIELDS IN YOUR OWN HOME" ELECTRONICS WORLD, NEXUS MEDIA COMMUNICATIONS, SWANLEY, KENT, GB, Bd. 97, Nr. 1673, 1. April 1992 (1992-04-01), Seiten 281-283, XP000282129 ISSN: 0959-8332
- PURANEN L ET AL: "SIMULTANEOUS MEASUREMENTS OF RF ELECTRIC AND MAGNETIC NEAR FIELDS THEORETICAL CONSIDERATIONS" IEEE TRANSACTIONS ON INSTRUMENTATION AND MEASUREMENT, IEEE SERVICE CENTER, PISCATAWAY, NJ, US, Bd. 42, Nr. 6, 1. Dezember 1993 (1993-12-01), Seiten 1001-1008, XP000418720 ISSN: 0018-9456

## Beschreibung

Die Erfindung betrifft einen Antennenkoppler zum Testen eines Sendegeräts und/oder eines Empfangsgeräts, insbesondere eines Mobiltelefons.

Ein Antennenkoppler wird zum Testen eines Sendegeräts und/oder eines Empfangsgeräts, insbesondere eines Mobiltelefons, verwendet. Der Antennenkoppler ermöglicht einen vollständigen Endtest des Mobiltelefons, da auch Funkeigenschaften des Mobiltelefons, insbesondere die Antennenwirkung, überprüft werden. Des Weiteren werden beim Test des Mobiltelefons eine Vielzahl von Eigenschaften und/oder Parametern des Mobiltelefons untersucht, die sich grob in Sender- und Empfängermessungen einteilen lassen. Bei einer Sendemessung wird beispielsweise eine Messung des Phasenfehler, des Frequenzfehlers, der Leistung und/oder des Spektrums durchgeführt. Bei einer Empfangsmessung werden beispielsweise Bitfehlerraten gemessen.

Die Kopplung des Sendegeräts und/oder des Empfangsgeräts erfolgt über ein am Antennenkoppler vorgesehenes Antennenelement, wobei sich der Kopplungsfaktor, welcher das Verhältnis der empfangenen Leistung in Bezug auf die abgestrahlte Gesamtleistung des Sendegeräts bzw. Empfangsgeräts angibt, bei Lageänderungen des Sendegeräts bzw. Empfangsgeräts möglichst unverändert bleiben soll. Aus der DE 101 29 408 A1 ist ein derartiger Antennenkoppler bekannt.

Zum Test eines in einem MIMO (Multiple In Multiple Out)-System, in einem Smart-Antenna System oder nach einem Antenna-Diversity Verfahren betriebenen Sendegeräts und/oder Empfangsgeräts mit einer Antennenanordnung, welche mehrere Antennen aufweist, erweist sich der in der DE 101 29 408 A1 offenbarte Antennenkoppler jedoch als unzureichend.

Der Erfindung liegt die Aufgabe zu Grunde, einen Antennenkoppler anzugeben, welcher sich besonders zum Test eines eine komplexe Abstrahlcharakteristik und/oder Empfangscharakteristik aufweisenden Sendegeräts bzw. Empfangsgeräts eignet.

Die genannte Aufgabe wird erfindungsgemäß gelöst durch die Merkmale des Anspruchs 1. Vorteilhafte Weiterbildungen sind Gegenstand der hierauf rückbezogenen Unteransprüche.

Zum Test eines eine besonders komplexe Abstrahlcharakteristik und/oder Empfangscharakteristik aufweisenden Sendegeräts bzw. Empfangsgeräts umfasst der Antennenkoppler mehrere Antennenelemente, welche derart an dem Antennenkoppler angeordnet sind, dass Hauptempfindlichkeitsrichtungen bzw. Hauptstrahlrichtungen der Antennenelemente des Antennenkopplers unterschiedlich im Raum orientiert sind. Des Weiteren umfasst der Antennenkoppler ein Halteelement zur Aufnahme des Sendegeräts bzw. Empfangsgeräts. Das Sendegerät bzw. Empfangsgerät ist insbesondere als Mobiltelefon ausgeführt.

Die mit der Erfindung erzielten Vorteile bestehen insbesondere darin, dass Eigenschaften eines in einem MIMO-System betriebenes Sendegeräts und/oder eines Empfangsgeräts, welches eine Antennenanordnung mit mehreren, beispielsweise linear unabhängig zueinander angeordneten Antennen aufweist, mittels des erfindungsgemäßen Antennenkopplers als Gesamtgerät (device under test) besonders zuverlässig analysierbar sind.

Des Weiteren ist der erfindungsgemäße Antennenkoppler auch zum Test eines in einem Smart-Antenna System oder nach dem Antenna-Diversity Verfahren betriebenen Sendegeräts und/oder Empfangsgeräts geeignet.

Ferner ist der erfindungsgemäße Antennenkoppler zum Empfangen und/oder Senden unterschiedlich polarisierter Wellen ausgebildet und eignet sich besonders zum Test eines Sendegeräts und/oder Empfangsgeräts, welches als Mobiltelefon oder als Blue-Tooth-Gerät ausgeführt ist.

Mit unterschiedlicher Orientierung der Hauptempfindlichkeitsrichtungen der Antennenelemente im Raum sind mittels des erfindungsgemäßen Antennenkopplers zudem Abstrahlcharakteristika des Sendegeräts, beispielsweise eines MIMO-Systems, für eine Sendermessung besonders genau analysierbar.

Für den Empängertest erzeugt der Antennenkoppler mittels unterschiedlicher Orientierung der Hauptstrahlrichtungen der Antennenelemente im Raum verschiedene Strahlungdiagrammkonfigurationen. Durch äußere Beschaltung des Antennenkopplers kann das Empfangsgerät mit Strahlen aus mehreren verschiedenen Richtungen gleichzeitig bestrahlt werden, wobei die verschiedenen Strahlen gleiche oder verschiedene Signale tragen können. Trägt ein Strahl das Nutzsignal und ein anderer das Störsignal, kann der richtungsseltive Empfang des Nutzsignals in Kombination mit der richtungsselektiven Unterdrückung des Störsignals getestet werden. Die Unterscheidbarkeit der Nutzsignale aus verschiedenen Strahlen ist das Wesen eines MIMO Systems und kann von diesem Antennenkoppler dargestellt werden. D.h. ein deratiger Antennenkoppler unterstützt nicht nur den besonders genauen Test der Empfänger- und Richtempfangsigenschaften, er ist auch, wie das letzte Beispiel zeigt, sinnvoll für Empfänger und Protokolltest eine MIMO Senders/Empfängers.

Gemäß vorteilhafter Ausgestaltung sind ein oder mehrere der Antennenelemente mit der Hauptempfindlichkeitsrichtung und/oder der Hauptstrahlrichtung in Richtung auf das Sendegerät bzw. Empfangsgerät ausgerichtet. Zweckmäßigerweise sind die Antennenelemente unabhängig voneinander ausrichtbar. Dazu umfasst der Antennenkoppler vorzugsweise eine Ausrichteinrichtung.

In zweckmäßiger Weiterbildung ist die an den Antennenelementen abgestrahlte Leistung an jedem Antennenelement durch Einspeisung separat einstellbar.

Gemäß vorteilhafter Weiterbildung sind die Antennenelemente jeweils in geeignetem Abstand zum Sendegerät und/oder zum Empfangsgerät am Antennenkoppler positioniert.

Je nach Messzweck beträgt der Abstand zwischen dem Sendegerät und/oder dem Empfangsgerät und einem oder mehreren der Antennenelemente des Antennenkopplers λ/4, (Nahfeld) oder mehrere λ (Fernfeld), wobei λ der Wellenlänge der von dem jeweiligen Antennenelement empfangenen bzw. abgestrahlten Welle entspricht.

Gemäß vorteilhafter Ausgestaltung sind auf Koordinatenachsen eines Koordinatensystem mehrere Antennenelemente des Antennenkopplers vorgesehen, wobei das Sendegerät und/oder Empfangsgerät zweckmäßigerweise im Koordinatenursprung angeordnet ist.

Gemäß vorteilhafter Weiterbildung verlaufen die Koordinatenachsen orthogonal zueinander, so dass das Koordinatensystem ein kartesisches Koordinatensystem ist.

Zur besonders genauen Analyse der Abstrahlcharakteristik und/oder der Empfangscharakteristik des Sendegeräts bzw. des Empfangsgeräts ist sowohl in positiver Koordinatenachsenrichtung als auch in negativer Koordinatenachsenrichtung auf den Koordinatenachsen des Koordinatensystems jeweils ein Antennenelement vorgesehen.

Gemäß vorteilhafter Ausgestaltung sind die Antennenelemente des Antennenkopplers an Ecken eines Oktaeders angeordnet, wobei das Sendegerät und/oder Empfangsgerät zweckmäßigerweise im Mittelpunkt des Oktaeders angeordnet ist.

Gemäß vorteilhafter Ausgestaltung sind die Antennenelemente des Antennenkopplers als Stabantennen, als Schleifenantennen, als Yagi-Antennen oder gemischt als Stabantennen, Yagi-Antennen und Schleifenantennen ausgeführt.

In zweckmäßiger Weiterbildung ist das als Schleifenantenne ausgebildete Antennenelement im wesentlichen kreisringförmig und zweckmäßigerweise als im wesentlichen geschlossene Schleife ausgebildet, wobei zwischen einem Einspeisepunkt an einem Einspeiseschleifenende und einem dem Einspeiseschleifenende gegenüberliegenden Schleifenende vorzugsweise ein möglichst geringer Abstand vorhanden ist. Das als Schleifenantenne ausgebildete Antennenelement umfasst zweckmäßigerweise einen Außenleiter und einen Innenleiter, welcher vorzugsweise im Bereich des Einspeiseschleifenends und/oder im Bereich des diesem gegenüberliegenden Schleifenends aus dem Außenleiter herausgeführt und zweckmäßigerweise mit dem Außenleiter elektrisch leitend verbunden ist. Gemäß vorteilhafter Ausgestaltung wird das als Schleifenantenne ausgebildete Antennenelement von einem beispielsweise aus Teflon bestehenden Halter gehalten.

Gemäß vorteilhafter Weiterbildung entspricht der Umfang des als Schleifenantenne ausgebildeten Antennenelements im wesentlichen der mittleren Wellenlänge λ der über das Antennenelement abgestrahlten und/oder empfangenen Welle.

Zweckmäßigerweise ist die Polarisationsrichtung der von dem als Schleifenantenne ausgebildeten Antennenelement abgestrahlten und/oder empfangenen Wellen einstellbar. Dazu ist das Antennenelement vorzugsweise um eine Mittelachse, welche lotrecht zu einer von der Schleife gebildeten Ebene orientiert ist, drehbar gelagert.

In zweckmäßiger Weiterbildung ist das als Schleifenantenne ausgebildete Antennenelement in Bezug auf das vorzugsweise im Koordinatenursprung des Koordinatensystems vorgesehene Sendegerät und/oder das Empfangsgerät derart ausgerichtet, dass die Mittelachse der Schleifenantenne auf das Sendegerät bzw. Empfangsgerät gerichtet ist.

In vorteilhafter Weiterbildung stimmen die Verbindungen zwischen den jeweiligen Antennenelementen des Antennenkopplers und dem äusseren Anschluss des Antennenkoppler in der elektrischen Länge überein und ist dem Anwender bekannt.

Um das Sendgerät und/oder Empfangsgerät am Halteelement zu fixieren, weist das Haltelement vorzugsweise eine Befestigungseinrichtung auf.

Nachfolgend werden Ausführungsbeispiele der Erfindung anhand einer Zeichnung näher erläutert. Darin zeigen
- Fig. 1: schematisch einen Längsschnitt durch einen Antennenkoppler mit als Schleifenantennen ausgeführten Antennenelementen und einem als Mobiltelefon ausgeführten Sendegerät und/oder Empfangsgerät;
- Fig. 2: schematisch eine Draufsicht eines Antennenkopplers mit als Schleifenantennen ausgeführten Antennenelementen und einem als Mobiltelefon ausgeführten Sendegerät und/oder Empfangsgerät;
- Fig. 3: schematisch eine Draufsicht eines Antennenkopplers mit als Stabantennen ausgeführten Antennenelementen und einem als Mobiltelefon ausgeführten Sendegerät und/oder Empfangsgerät und
- Fig. 4: schematisch eine Draufsicht eines Antennenkopplers mit als Yagi-Antennen ausgeführten Antennenelementen und einem als Mobiltelefon ausgeführten Sendegerät und/oder Empfangsgerät.

Einander entsprechende Teile sind in allen Figuren mit den gleichen Bezugszeichen versehen.

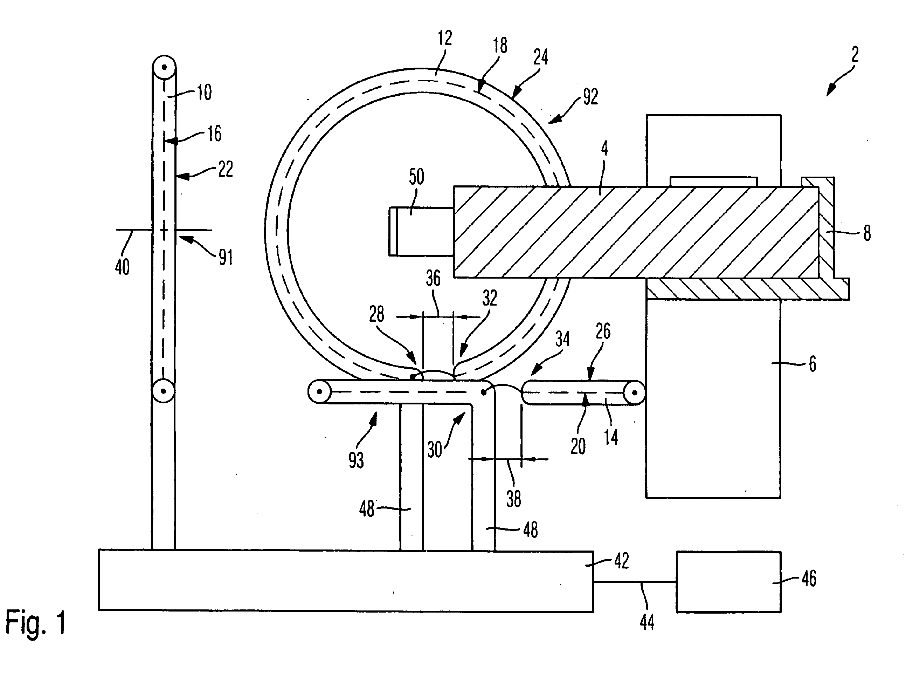

Fig. 1 zeigt schematisch einen Längsschnitt durch einen Antennenkoppler 2 zum Testen eines als Sendegerät und/oder Empfangsgerät ausgeführten Mobiltelefons 4, welches an einem Halteelement 6 aufgenommen und an einer Befestigungseinrichtung 8 fixiert ist. Der Antennenkoppler 2 umfasst im Ausführungsbeispiel gemäß Fig. 1 drei als Schleifenantennen 10,12,14 ausgeführte Antennenelemente 91, 92, 93.

Die jeweilige Schleifenantenne 10,12,14 weist einen in Fig. 1 mit gestrichelter Linie gekennzeichneten Innenleiter 16,18,20 und einen den Innenleiter 18,20,22 umgebenden Außenleiter 22,24,26 auf, welcher den Innenleiter 16,18,20 abschirmt. Der Außenleiter 22,24,26 umschließt den Innenleiter 16,18,20 zylindermantelförmig. Zwischen dem Innenleiter 16,18,20 und dem Außenleiter 22,24,26 ist vorzugsweise ein in Fig. 1 nicht gezeigtes Dielektrikum vorgesehen. Die Schleifenantenne 10,12,14 ist im wesentlichen als räumlich geschlossene Schleife ausgebildet, wobei zwischen einem in Fig. 1 lediglich an der Schleifenantenne 12,14 sichtbaren Einspeisepunkt 28,30 an einem Einspeiseschleifenende und einem diesem gegenüberliegenden Schleifenende 32,34 ein möglichst geringer Abstand 36,38 besteht. An dem Schleifenende 32,34 der Schleifenantenne 12,14 ist der Innenleiter 18,20 aus dem Außenleiter 24,26 herausgeführt. Der Innenleiter 18,20 wird im Bereich des Einspeisepunkts 28,30 am Einspeiseschleifenende auf den Außenleiter 24,26 geführt, um einen elektrischen Kontakt zwischen dem Innenleiter 18,20 und dem Außenleiter 24,26 herzustellen.

Die Schleifenantenne 10,12,14 ist vorzugsweise von einem in Fig. 1 nicht dargestellten Halter gehalten. Durch Drehung der Schleifenantenne 10,12,14 um eine lotrecht zu einer von der Schleife der Schleifenantenne 10 gebildeten Ebene stehenden Mittelachse 40, welche in Fig. 1 lediglich für die Schleifenantenne 10 gekennzeichnet ist, sind die Polarisationsrichtung von von der Schleifenantenne 10,12,14 abgestrahlten Wellen veränderbar und/oder Wellen unterschiedlicher Polarisation über die Schleifenantenne 10,12,14 detektierbar.

Die Schleifenantennen 10,12,14 sind jeweils mit einem Antennenfuss 42 gekoppelt, welche über eine Signalleitung 44 mit einer Mess- und Steueranordnung 46 verbunden ist.

Um eine vorteilhafte Abstrahlcharakteristik und/oder Empfangscharakteristik zu erreichen, entspricht der Umfang der Schleifenantennen 10,12,14 im wesentlichen jeweils der mittleren Wellenlänge λ der Wellen, welche von den Schleifenantennen 10,12,14 abgestrahlt bzw. empfangen werden.

Bei einer Anordnung mehrerer Antennenelemente mit im Raum unterschiedlich orientierten Hauptstrahlrichtungen und/oder Hauptempfindlichkeitsrichtungen, welche im Ausführungsbeispiel gemäß Fig. 1 mit drei als Schleifenantennen 10,12,14 ausgeführten Antennenelementen vorzufinden ist, sind die elektrische und magnetische Komponente eines von einer Antennenanordnung 50 des Mobiltelefons 4 abgestrahlten elektrischen Feldes besonders genau messbar.

Außerdem ist der Kopplungsfaktor bei den als Schleifenantennen 10,12,14 ausgebildeten Antennenelementen zwischen den Schleifenantennen 10,12,14 und der Antennenanordnung 50, welche beispielsweise zur Realisierung eines MIMO-Systems am Mobiltelefon mehrere Antennen aufweist, im wesentlichen unabhängig von der genauen geometrischen Lage der Antennenanordnung 50 in Bezug auf die Schleifenantennen 10,12,14, wodurch eine räumlich präzise Justage des die Antennenanordnung 50 umfassenden Mobiltelefons 4 am Antennenkoppler 2 nicht erforderlich ist.

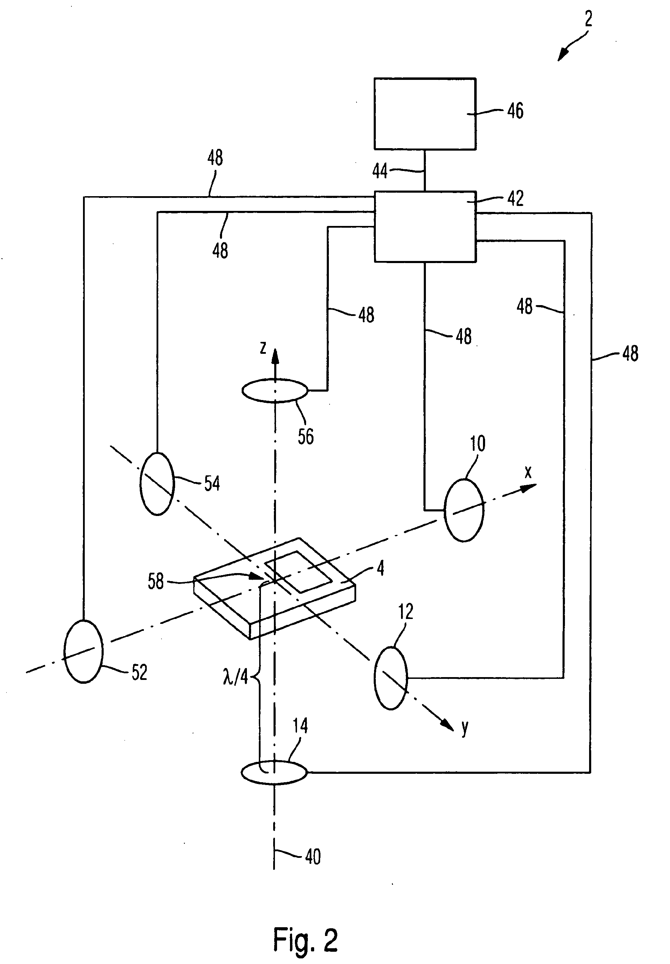

Fig. 2 zeigt eine schematische Draufsicht des Antennenkoppler 2 in einem weiteren Ausführungsbeispiel. Als Schleifenantennen 10,12,14,52,54,56 ausgeführte Antennenelemente sind im wesentlichen an den Ecken eines Oktaeders angeordnet. Zur Verdeutlichung der oktaederförmigen Anordnung der Schleifenantennen 10,12,14,52,54,56 sind in Fig. 2 Koordinatenachsen x, y, z eines kartesischen Koordinatensystems gestrichelt gezeigt. Die Schleifenantennen 10,12,14,52,54,56 sind auf den Koordinatenachsen x, y, z in negativer als auch in positiver Koordinatenachsenrichtung positioniert, wobei die lotrecht auf von Schleifen der Schleifenantennen 10,12,14,52,54,56 gebildeten Ebenen stehenden Mittelachsen 40 der Schleifenantennen 10,12,14,52,54,56 entlang den Koordinatenachsen x, y, z verlaufen und sich in einem Koordinatenursprung 58 schneiden, worin das Mobiltelefon 4 positioniert ist. Im Ausführungsbeispiels gemäß Fig. 2 ist die Antennenanordnung des Mobiltelefons 4 in diesem integriert ausgeführt und deshalb in Fig. 2 nicht sichtbar.

Die jeweilige Schleifenantenne 10, 12, 14, 52, 54, 56 ist im wesentlichen im Abstand λ/4 zum Mobiltelefon 4 beabstandet angeordnet. Ferner sind die Schleifenantennen 10,12,14,52,54,56 über Verbindungsleitungen 48 zum Antennenfuss 42 geführt, welche jeweils die gleiche elektrische Länge aufweisen.

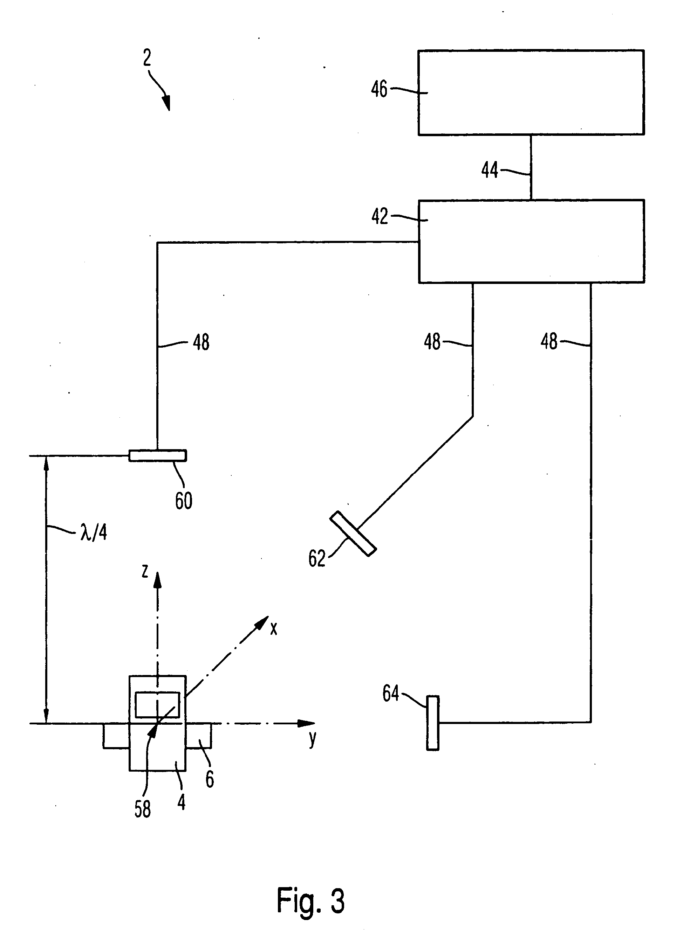

Fig. 3 zeigt eine schematische Draufsicht des Antennenkopplers 2 mit drei als Stabantennen 60,62,64 ausgeführten Antennenelementen und einem als Mobiltelefon 4 ausgeführten Sendegerät und/oder Empfangsgerät in einem weiteren Ausführungsbeispiel. Das Mobiltelefon 4 ist im Halteelement 6 aufgenommen und umfasst eine integrierte, in Fig. 3 nicht sichtbare Antennenanordnung.

Die als Stabantennen 60,62,64 ausgeführten Antennenelemente sind mit der jeweiligen Querachse des Stabes der Stabantenne 60,62,64 auf das im Koordinatenursprung 58 positionierte Mobiltelefon 4 ausgerichtet und die Hauptabstrahlrichtungen verlaufen auf den Koordinatenachsen x, y, z des kartesischen Koordinatensystems, welche in Fig. 3 gestrichelt dargstellt sind. Die Abstände zwischen dem Mobiltelefon 4, insbesondere zwischen der in diesem integrierten Antennenanordnung, und der jeweiligen Stabantenne 60,62,64 stimmen miteinander überein und betragen im wesentlichen λ/4 der mittleren Wellenlänge der von der Stabantenne 60,62,64 abgestrahlten und/oder empfangenen Wellen.

Die Stabantennen 60,62,64 sind über Verbindungsleitungen 48, welche jeweils die gleiche elektrische Länge aufweisen zum Antennenfuss 42 geführt.

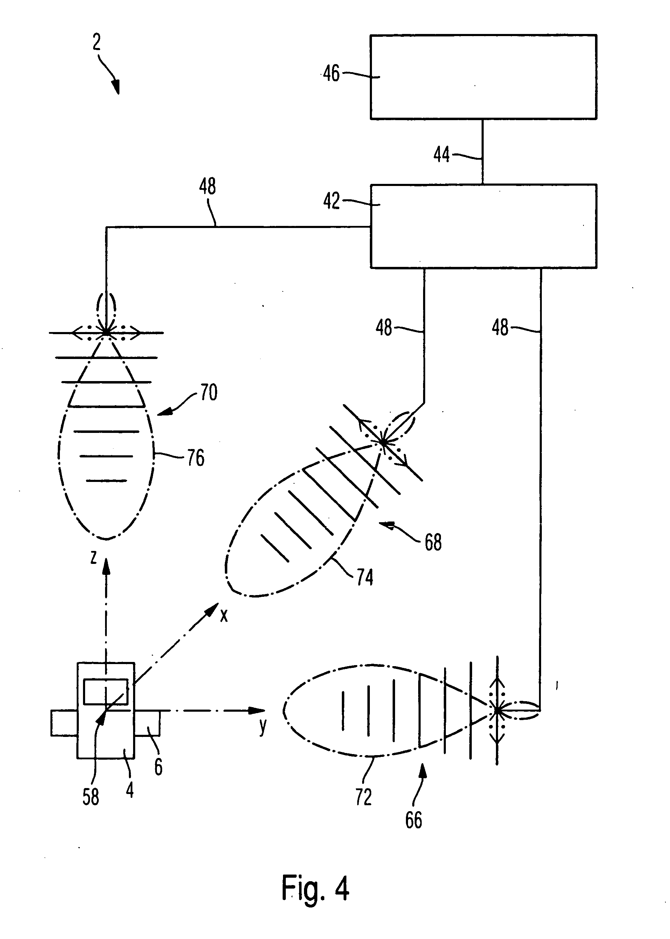

Fig. 4 zeigt eine schematische Draufsicht des Antennenkopplers 2 mit drei als Yagi-Antennen 66,68,70 ausgeführten Antennenelementen und dem als Mobiltelefon 4 ausgeführten Sendegerät und/oder Empfangsgerät in einem weiteren Ausführungsbeispiel. Das Mobiltelefon 4 ist im Halteelement 6 aufgenommen und umfasst eine integrierte, in Fig. 3 nicht sichtbare Antennenanordnung.

Entsprechend dem Ausführungsbeispiel gemäß Fig. 3 sind die Yagi-Antennen 66,68,70 im Ausführungsbeispiel gemäß Fig. 4 auf Koordinatenachsen x, y, z des kartesischen Koordinatensystems mit dem im Koordinatenursprung 58 angeordneten Mobiltelefon 4 vorgesehen und weisen jeweils den gleich Abstand zum Mobiltelefon 4 auf. Dabei zeigen Hauptkeulen 72,74,76 der Yagi-Antennen 66,68,70 jeweils auf in Richtung das Mobiltelefon 4.

Die Yagi-Antennen 66,68,70 sind über Verbindungsleitungen 48, welche jeweils die gleiche elektrische Länge aufweisen zum Antennenfuss 42 geführt.

Die Erfindung ist nicht auf die in der Zeichnung dargestellten Ausführungsbeispiele, insbesondere nicht die in den Ausführungsbeispielen gezeigten Antennenelementanordnungen des Antennenkopplers und auf das als Mobiltelefon ausgeführte Sendegerät bzw. Empfangsgerät, beschränkt. Unter Umständen können die Antennenelemente auch entlang der x-, y- bzw. z-Achse verschiebbar oder um eine dazu senkrechte Achse schwenkbar sein. Alle vorstehend beschriebenen und in der Zeichnung dargestellten Merkmale sind beliebig miteinander kombinierbar.

## Patentansprüche

1. Antennenkoppler zum Testen eines Sendegeräts und/oder Empfangsgerät (4) mit einem Halteelement (6) für das Sendegerät bzw. Empfangsgerät (4) und mit mehreren Antennenelementen (91, 92, 93), welche derart angeordnet sind, dass Hauptstrahlrichtungen bzw. Hauptempfindlichkeitsrichtungen der Antennenelemente (91, 92, 93) unterschiedlich zueinander im Raum orientiert sind, wobei eine Verschiebung und/oder eine Schwenkung für jedes Antennenelement (91-93) separat durchfürbar ist.

2. Antennenkoppler nach Anspruch 1,
**dadurch gekennzeichnet,**
**dass** ein oder mehrere der Antennenelemente mit Hauptempfindlichkeitsrichtungen und/oder Hauptstrahlrichtungen in Richtung auf das Sendegerät bzw. das Empfangsgerät ausgerichtet sind.

3. Antennenkoppler nach Anspruch 1 oder 2,
**dadurch gekennzeichnet,**
**dass** die an den Antennenelementen (91-93) abgestrahlte Leistung für jedes Antennenelement (91, 92, 93) separat einstellbar ist.

4. Antennenkoppler nach einem der Ansprüche 1 bis 3,
**dadurch gekennzeichnet,**
**dass** die Antennenelemente (91-93) jeweils in variablen Abständen zum Sendegerät und/oder Empfangsgerät (4) positionierbar sind.

5. Antennenkoppler nach einem der Ansprüche 1 bis 4,
**dadurch gekennzeichnet,**
**dass** der Abstand zwischen dem jeweiligen Antennenelement (91-93) und dem Sendegerät bzw. Empfangsgerät (4) im wesentlichen λ/4 beträgt, wobei λ der mittleren Wellenlänge der vom Antennenelement empfangenen bzw. abgestrahlten Wellen entspricht.

6. Antennenkoppler nach einem der Ansprüche 1 bis 5,
**dadurch gekennzeichnet,**
**dass** jeweils ein Antennenelement auf einer Koordinatenachse (x, y, z) eines Koordinatensystems angeordnet ist, wobei das Sendegerät und/oder Empfangsgerät (4) in einem Koordinatenursprung (58) des Koordinatensystems von dem Halteelement (6) positioniert ist.

7. Antennenkoppler nach Anspruch 6,
**dadurch gekennzeichnet,**
**dass** die Koordinatenachsen (x, y, z) im Koordinatensystem orthogonal zueinander ausgerichtet sind.

8. Antennenkoppler nach Anspruch 6 oder 7,
**dadurch gekennzeichnet,**
**dass** in positiver Koordinatenachsenrichtung und/oder in negativer Koordinatenachsenrichtung jeweils ein Antennenelement (10, 52; 12, 54; 14, 56) auf einer der Koordinatenachsen (x, y, z) vorgesehen ist.

9. Antennenkoppler nach einem der Ansprüche 1 .bis 8,
**dadurch gekennzeichnet,**
**dass** die Antennenelemente an den Ecken eines Oktaeders angeordnet sind, wobei das Halteelement (6) das Sendegerät und/oder Empfangsgerät (4) im Mittelpunkt des Oktaeders positioniert.

10. Antennenkoppler nach einem der Ansprüche 1 bis 9,
**dadurch gekennzeichnet,**
**dass** die Antennenelemente als Stabantennen (60, 62, 64) und/oder als Yagi-Antennen (66, 68, 70) und/oder als Schleifenantennen (10, 12, 14, 52, 54, 56) ausgeführt sind.

11. Antennenkoppler nach einem der Ansprüche 1 bis 9,
**dadurch gekennzeichnet,**
**dass** eine Schleife des als eine Schleifenantenne (10, 12, 14, 52, 54, 56) ausgeführten Antennenelements kreisringförmig ausgebildet ist.

12. Antennenkoppler nach Anspruch 11,
**dadurch gekennzeichnet,**
**dass** ein Umfang der Schleife des als Schleifenantenne (10, 12, 14, 52, 54, 56) ausgeführten Antennenelements der mittleren Wellenlänge λ der über das Antennenelement empfangenen bzw. abgestrahlten Wellen entspricht.

13. Antennenkoppler nach einem der Ansprüche 10 bis 12,
**dadurch gekennzeichnet,**
**dass** zumindest ein als Schleifenantenne (10, 12, 14, 52, 54, 56) ausgeführte Antennenelement zur Einstellung einer Polarisationsrichtung von über das Antennenelement abgestrahlten und/öder empfangenen Wellen um eine Mittelachse (40) drehbar gelagert ist, welche zu einer von einer Schleife der Schleifenantenne gebildeten Ebene lotrecht orientiert ist.

14. Antennenkoppler nach Anspruch 13,
**dadurch gekennzeichnet,**
**dass** zumindest ein als Schleifenantenne (10, 12, 14, 52, 54, 56) ausgeführtes Antennenelement in Bezug auf das von dem Halteelement (6) im Koordinatenursprung (58) des Koordinatensystems positionierten Sendegerät und/oder Empfangsgerät (4) derart ausgerichtet ist, dass die Mittelachse (39) der Schleifenantenne (10, 12, 14, 52, 54, 56) entlang einer der Koordinatenachsen (x, y, z) des Koordinatensystems verläuft.

15. Antennenkoppler nach einem der Ansprüche 1 bis 14,
**dadurch gekennzeichnet,**
**dass** jede Verbindungsleitung (48) zwischen jeweils einem an jedem der Antennenelemente vorgesehenen Einspeisepunkt (28, 30) und einem Antennenfuß (42) des Antennenkopplers (2) die gleiche elektrische Länge aufweist.

16. Antennenkoppler nach einem der Ansprüche 1 bis 15,
**dadurch gekennzeichnet,**
**dass** das Halteelement (6) eine Befestigungseinrichtung (8) zur Fixierung des Sendegeräts bzw. des Empfangsgeräts aufweist.

## Claims

1. An antenna coupler for testing a transmitter device and/or receiver device (4) with a holding element (6) for the transmitter device and/or receives device (4) and with several antenna elements (91, 92, 93), which are arranged in such a manner that main radiation directions or respectively main sensitivity directions of the antenna elements 91, 92, 93) are orientated in space differently relative to one another, wherein a displacement and/or a rotation can be implemented separately for each antenna element (91-93).

2. The antenna coupler according to claim 1,
**characterised in that**
one or more of the antenna elements are orientated with main sensitivity directions and/or main radiation directions in the direction towards the transmitter device and/or the receiver device.

3. The antenna coupler according to claim 1 or 2,
**characterised in that**
the power radiated at the antenna elements (91-93) is separately adjustable for each antenna element (91, 92, 93).

4. The antenna coupler according to any one of claim 1 to 3,
**characterised in that**
the antenna elements (91-93) can each be positioned at variable spacing distances relative to the transmitter device and/or receiver device (4).

5. The antenna coupler according to any one of claims 1 to 4,
**characterised in that**
the spacing distance between the respective antenna element (91-93) and the transmitter device and/or receiver device (4) is substantially λ/4, wherein λ corresponds to the mean wavelength of the waves received by or radiated from the antenna clement.

6. The antenna coupler according to any one of claims 1 to 5,
**characterised in that**,
in each case an antenna element is arranged on a coordinate axis (x, y, z) of a coordinate system, wherein the transmitter device and/or receiver device (4) is positioned by the holding element (6) at a coordinate origin (58) of the coordinate system.

7. The antenna coupler according to claim 6,
**characterised in that**
the coordinate axes (x, y, z) are orientated orthogonally relative to one another within the coordinate system.

8. The antenna coupler according to claim 6 or 7,
**characterised in that**,
in each case, one antenna element (10, 52; 12, 54; 14, 56) is provided on one of the coordinate axes in the positive coordinate axis direction and/or in the negative coordinate axis direction.

9. The antenna coupler according to any one of claims 1 to 8,
**characterised in that**
the antenna elements are arranged at the corners of an octahedron, wherein the holding element positions the transmitter device and/or receiver device (4) at the centre point of the octahedron.

10. The antenna coupler according to any one of claims 1 to 9,
**characterised in that**
the antenna elements are designed as rod antennae (60, 62, 64) and/or as yagi antennae (66, 68, 70) and/or as loop antennae (10, 12, 14, 52, 54, 56).

11. The antenna coupler according to any one of claims 1 to 9,
**characterised in that**
one loop of the antenna element designed as a loop antenna (10, 12, 14, 52, 54, 56) is formed in the shape of a circular ring.

12. The antenna coupler according to claim 11,
**characterised in that**
the circumference of the loop of the antenna element designed as a loop antenna (10, 12, 14, 52, 54, 56) corresponds to the mean wavelength λ of the waves received and/or radiated via the antenna element.

13. The antenna coupler according to any one of claims 10 to 12,
**characterised in that**,
in order to adjust a polarisation direction of waves radiated and/or received via the antenna element, at least one antenna element designed as a loop antenna (10, 12, 14, 52, 54, 56) is mounted in a rotatable manner about a central axis (40), which is orientated perpendicular to a plane formed by a loop of the loop antenna.

14. The antenna coupler according to claim 13,
**characterised in that**
at least one antenna element designed as a loop antenna (10, 12, 14, 52, 54, 56) is orientated relative to the transmitter device and/or receiver device (4) positioned by the holding element (6) at the coordinate origin (58) of the coordinate system in such a manner that the central axis (39) of the loop antenna (10, 12, 14, 52, 54, 56) extends along one of the coordinate axes (x, y, z) of the coordinate system.

15. The antenna coupler according to any one of claims 1 to 14,
**characterised in that**
every connecting line (48) in each case between a feeding point (28, 30) provided on each of the antenna elements and an antenna base (42) of the antenna coupler (2) provides the same electrical length.

16. The antenna coupler according to any one of claims 1 to 15,
**characterised in that**
the holding element (6) provides an attachment device (8) for fixing the transmitter device and/or the receiver device.

## Revendications

1. Coupleur d'antennes destiné à tester un appareil émetteur et/ou un appareil récepteur (4), comprenant un élément de support (6) pour l'appareil émetteur respectivement l'appareil récepteur (4), ainsi que plusieurs éléments d'antenne (91, 92, 93) qui sont agencés de façon telle, que des directions principales de rayonnement respectivement des directions principales de sensibilité ou de réponse des éléments d'antenne (91, 92, 93) soient orientées différemment les unes par rapport aux autres dans l'espace, une translation et/ou un pivotement pouvant être effectués séparément pour chaque élément d'antenne (91-93).

2. Coupleur d'antennes selon la revendication 1,
**caractérisé**
**en ce que** l'un ou plusieurs des éléments d'antenne sont orientés, avec des directions principales de réponse et/ou des directions principales de rayonnement, en direction de l'appareil émetteur respectivement de l'appareil récepteur.

3. Coupleur d'antennes selon la revendication 1 ou la revendication 2,
**caractérisé**
**en ce que** la puissance rayonnée au niveau des éléments d'antenne (91-93) peut être réglée séparément pour chaque élément d'antenne (91, 92, 93).

4. Coupleur d'antennes selon l'une des revendications 1 à 3,
**caractérisé**
**en ce que** les éléments d'antenne (91-93) peuvent être positionnés respectivement selon des distances variables à l'appareil émetteur et/ou à l'appareil récepteur (4).

5. Coupleur d'antennes selon l'une des revendications 1 à 4,
**caractérisé**
**en ce que** la distance entre l'élément d'antenne (91-93) respectivement considéré et l'appareil émetteur ou respectivement l'appareil récepteur (4) est d'une valeur sensiblement égale à λ/4, λ correspondant à la longueur d'onde moyenne des ondes reçues et respectivement rayonnées par l'élément d'antenne.

6. Coupleur d'antennes selon l'une des revendications 1 à 5,
**caractérisé**
**en ce que** chaque élément d'antenne est agencé sur un axe de coordonnées (x, y, z) d'un système de coordonnées, l'appareil émetteur et/ou l'appareil récepteur (4) étant positionné par l'élément de support (6) sur une origine de coordonnées (58) du système de coordonnées.

7. Coupleur d'antennes selon la revendication 6,
**caractérisé**
**en ce que** les axes de coordonnées (x, y, z) sont orientés de manière orthogonale les uns par rapport aux autres dans le système de coordonnées.

8. Coupleur d'antennes selon la revendication 6 ou la revendication 7,
**caractérisé**
**en ce que** dans la direction positive d'axe de coordonnées et/ou dans la direction négative d'axe de coordonnées, il est prévu respectivement un élément d'antenne (10, 52 ; 12, 54 ; 14, 56) sur un des axes de coordonnées (x, y, z).

9. Coupleur d'antennes selon l'une des revendications 1 à 8,
**caractérisé**
**en ce que** les éléments d'antenne sont agencé aux sommets d'un octaèdre, l'élément de support (6) positionnant l'appareil émetteur et/ou l'appareil récepteur (4) au centre de l'octaèdre.

10. Coupleur d'antennes selon l'une des revendications 1 à 9,
**caractérisé**
**en ce que** les éléments d'antenne sont réalisés en tant qu'antennes en barreau (60, 62, 64), et/ou en tant qu'antennes Yagi (66, 68, 70), et/ou en tant qu'antennes en boucle (10, 12, 14, 52, 54, 56).

11. Coupleur d'antennes selon l'une des revendications 1 à 9,
**caractérisé**
**en ce qu'**une boucle de l'élément d'antenne réalisé en tant qu'antenne en boucle (10, 12, 14, 52, 54, 56) est de forme annulaire circulaire.

12. Coupleur d'antennes selon la revendication 11,
**caractérisé**
**en ce qu'**un périmètre de la boucle de l'élément d'antenne réalisé en tant qu'antenne en boucle (10, 12, 14, 52, 54, 56) correspond à la longueur d'onde moyenne À des ondes reçues et respectivement rayonnées par l'intermédiaire de l'élément d'antenne.

13. Coupleur d'antennes selon l'une des revendications 10 à 12,
**caractérisé**
**en ce qu'**au moins un élément d'antenne réalisé en tant qu'antenne en boucle (10, 12, 14, 52, 54, 56) est monté, en vue du réglage d'une direction de polarisation d'ondes rayonnées et/ou reçues par l'intermédiaire de l'élément d'antenne, de manière rotative autour d'un axe central (40), qui est orienté perpendiculairement à un plan formé par une boucle de l'antenne en boucle.

14. Coupleur d'antennes selon la revendication 13,
**caractérisé**
**en ce qu'**au moins un élément d'antenne réalisé en tant qu'antenne en boucle (10, 12, 14, 52, 54, 56) est orienté, par rapport à l'appareil émetteur et/ou l'appareil récepteur (4) positionné par l'élément de support (6) à l'origine des coordonnées (58) du système de coordonnées, de façon telle que l'axe central (39) de l'antenne en boucle (10, 12, 14, 52, 54, 56) s'étende le long de l'un des axes de coordonnées (x, y, z) du système de coordonnées.

15. Coupleur d'antennes selon l'une des revendications 1 à 14,
**caractérisé**
**en ce que** chaque conducteur de raccordement (48) entre respectivement un point d'alimentation (28, 30) prévu sur chacun des éléments d'antenne, et un pied d'antenne (42) du coupleur d'antennes (2), présente la même longueur électrique.

16. Coupleur d'antennes selon l'une des revendications 1 à 15,
**caractérisé**
**en ce que** l'élément de support (6) comporte un dispositif de fixation (8) pour fixer l'appareil émetteur respectivement l'appareil récepteur.
